# EUROPÄISCHE PATENTSCHRIFT

(11) **EP 1 879 441 B1**
(45) Veröffentlichungstag und Bekanntmachung des Hinweises auf die Patenterteilung: **17.08.2016**
(21) Anmeldenummer: 07012970.5
(22) Anmeldetag: 03.07.2007
(51) Int. Cl.: H05K 7/14

(54) **Andruckvorrichtung für eine Leiterplatte**
Pressing device for a PCB
Dispositif de compression pour une plaque conductrice

(30) Priorität: 13.07.2006 DE 202006010806 U
(43) Veröffentlichungstag der Anmeldung: 16.01.2008
(73) Patentinhaber: HARTING Electronics GmbH, 32339 Espelkamp (DE)
(72) Erfinder: Lüttermann, Dieter, 32369 Rahden (DE); Pape, Günter, 32130 Enger (DE)

(56) Entgegenhaltungen:
- WO-A1-95/10864
- DE-A1- 19 833 248
- US-A- 3 899 721
- US-A- 5 392 629
- US-A- 5 467 254

## Beschreibung

Die Erfindung betrifft eine Vorrichtung gemäß dem Oberbegriff des unabhängigen Patentanspruchs 1..

Eine derartige Vorrichtung wird benötigt, um eine mechanisch exakte Führung von auf einer Leiterplatte angeordneten Kontaktbahnen zu den in einem Kartenrandsteckverbinder geführten elektrische Kontakten sicherzustellen.

### Stand der Technik

Allgemeine direkte Steckverbindungen zwischen Leiterplatten und dazu vorgesehenen Leiterplatten-Steckverbindern weisen bei einem relativ großen Kontaktraster (> 1mm) kaum Toleranzprobleme zwischen den Kontakten auf der Leiterplatte zu den elektrischen Kontakten innerhalb des Steckverbinders auf.
Wird das Kontaktraster jedoch verkleinert, ist eine erhöhte Präzision bei der Leiterplattenfertigung erforderlich, was zwangsläufig höhere Kosten nach sich zieht. Ansonsten können Fehlsteckungen aufgrund der relativ großen Fertigungstoleranzen bei den bisher üblichen Leiterplatten zu den exakter geführten Kontakten im Steckverbinder kaum vermieden werden.

### Aufgabenstellung

Der Erfindung liegt daher die Aufgabe zugrunde, eine Vorrichtung der eingangs genannten Art dahingehend auszubilden, dass unter Berücksichtigung der groben Fehlertoleranzen bei der Leiterplattenfertigung eine größtmögliche mechanische Übereinstimmung der Lage der Kontaktbahnen auf der Leiterplatte mit den Kontakten im Kartenrandsteckverbinder erzielt wird.

Diese Aufgabe wird mit einer Vorrichtung der eingangs erwähnten Art durch die Merkmale des kennzeichnenden Teils des unabhängigen Patentanspruchs 1 gelöst.

Vorteilhafte Ausgestaltungen der Erfindung sind in den Ansprüchen 2 - 7 angegeben.

Die mit der Erfindung erzielten Vorteile bestehen insbesondere darin, dass die relativ groben Maßtoleranzen, die fertigungsbedingt bei der Herstellung eines Steckbereiches an einer Leiterplatte scheinbar nicht unterschritten werden können, mittels des erfindungsgemäßen Federelementes so weit minimiert werden, dass auch abstandsmäßig eng beieinander angeordnete Buchsenkontakte im Kartenrandsteckverbinder präzise kontaktiert werden.

Werden die Leiterbahnkontakte zu den Buchsenkontakten nicht exakt geführt, sind Fehlsteckungen bzw. im Extremfall Kurzschlüsse unvermeidbar.

Dies ist insbesondere der Fall, wenn der Steckbereich einer Leiterkarte in den Steckschlitz eines Kartenrandsteckverbinders eingeschoben wird, und keine definierte Führung der Leiterplatte zum Steckverbinder vorgesehen ist, respektive der elektrischen Kontakte zueinander. Denn auch in der Längsausdehnung des Steckschlitzes sind wiederum Maßtoleranzen enthalten. Werden jedoch Kontaktabstände kleiner 1 mm benötigt, so können von den Leiterplattenherstellern nicht mehr die benötigten engen Toleranzen beidseitig des Steckbereiches garantiert werden.

Zum Einfügen in den Kartenrandsteckverbinder wird die Leiterplatte beidseitig in einer Führungsschiene gehalten, die wiederum in einem Leiterplatteneinschubgehäuse eingerastet ist oder das Gehäuse weist eine Boden- und eine Deckplatte auf, aus der Führungsstege herausragen in denen die Leiterplatte ähnlich einer Führungsschiene geführt ist.

Für eine präzise Führung der Leiterplatte in einem Kartenrandsteckverbinder ist eine enge Tolerierung der ersten Kontaktbahn auf der Leiterplatte zu der Anlagekante im Kartenrandsteckverbinder erforderlich.

Dazu wird der Kartenrandsteckverbinder auf eine minimale Höhentoleranz zu einer der beiden Führungsschienen eingestellt, zwischen denen die Leiterplatte geführt wird.
In der zweiten Führungsschiene ist ein Federelement angeordnet, dessen Federarm in Einschubrichtung der Leiterplatte ausgerichtet ist.
Beim Einschieben der Leiterplatte wird von dem Federelement Druck auf die Schmalseite der Leiterplatte ausgeübt, so dass eine zuvor zwischen den Führungsschiene lose einschiebbare Leiterplatte, kurz vor der Kontaktierung der Leiterbahnen mit den elektrischen Kontakten, exakt geführt, in den Kartenrandsteckverbinder eingeschoben wird.

Dabei ist das Federelement als angeformtes oder als separates Element in einer der Führungsschienen positioniert und kann als Kunststoffteil oder als Metallteil ausgeführt sein.

### Ausführungsbeispiel

Ein Ausführungsbeispiel der Erfindung ist in der Zeichnung dargestellt und wird im folgenden näher erläutert. Es zeigen:
- Fig.1: eine Ansicht einer Backplane mit einem Kartenrandsteckverbinder und einer zwischen zwei Führungsschienen angeordneten Leiterplatte vor dem Steckvorgang,
- Fig. 2: eine Detailansicht aus Fig.1, vor dem Steckvorgang,
- Fig. 3: eine Detailansicht aus Fig. 1, nach dem Steckvorgang,
- Fig. 4a: eine Ansicht einer zwischen einer Boden- und einer Deckplatte eingeschobenen Leiterplatte,
- Fig. 4b: eine Detailansicht eines Federelementes aus Fig. 4a,
- Fig. 5a: eine Ansicht eines separaten Federelementes in einer Deckplatte, und
- Fig. 5b: eine Schnittansicht des Federelementes mit einer gesteckten Karte.

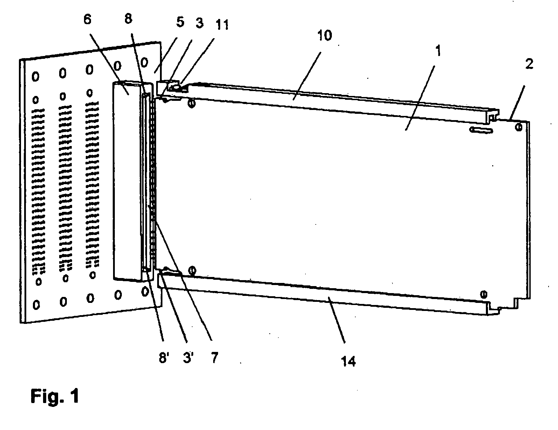

In der Fig.1 ist eine Anordnung von einer Leiterplatte 1 für eine direkte Steckung mit einem Kartenrandsteckverbinder 6 gezeigt, der auf einer so genannten Backplane 5 fixiert ist.
Die Leiterplatte 1 ist zwischen zwei Führungsschienen 10, 14 eingeschoben, die üblicherweise an einer hier nicht gezeigten Deck- bzw. Bodenplatte oder auch entsprechenden Tragschienen befestigt sind.

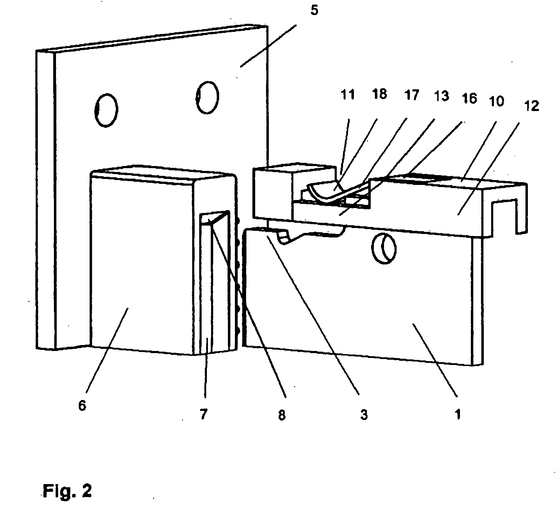

In unmittelbarer Nähe des Kartenrandsteckverbinders 6 weist die hier obere Führungsschiene 10 einen Ausschnitt 11 auf, der in der Fig. 2 im Detail dargestellt ist.
Innerhalb der aus der Basis der U-förmigen Schiene 10 in die Seitenschenkel 12 reichende Ausnehmung 11 ist ein Federelement 16 angeordnet, dessen Federarm 17 mit der Verrundung 18 auf den hier als Streben 13 ausgebildeten Seitenschenkeln aufliegt. Wobei die Ausnehmung so gestaltet ist, dass die Verrundung 18 des Federarmes 17 in den U-förmigen Ausschnitt 11 der Führungsschiene hineinreicht.
Dabei wird ein aus einem metallischen Material geformtes Federelement 16 in die üblicherweise aus einem Kunststoff hergestellte obere Führungsschiene 10 eingefügt oder das Federelement ist aus dem Material der Führungsschiene herausgeformt.

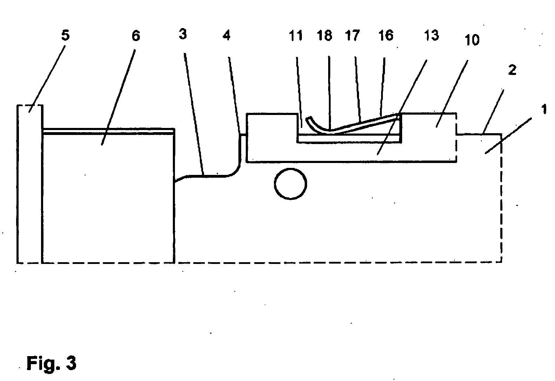

Wie aus der Fig. 3 ersichtlich, weist die in der oberen Führungsschiene 10 geführte Leiterplatte 1 an ihrer Steckseite eine Abstufung 3 auf, wobei der dadurch verjüngte vordere Abschnitt in den Steckschlitz 7 des Kartenrandsteckverbinders 6 einzuschieben ist.
Bis kurz vor dem Einschieben der Leiterkarte in den Kartenrandsteckverbinder liegt der Federarm 17 innerhalb der Ausnehmung 11 auf den Seitenstreben 13 auf, sobald die Leiterplatte 1 mit der Kante 4 an die Verrundung 18 des Federarmes 17 gelangt, wird die zuvor mit einigem Höhenspiel zwischen den Führungsschienen 10, 14 einschiebbare Leiterplatte 1 gegen die untere Führungsschiene 14 gedrückt.
Die untere Führungsschiene 14 ist jedoch auf eine enge Toleranz mit der unteren Kante 8' des Steckschlitzes 7 des Kartenrandsteckverbinders 6 abgestimmt, so dass eine exakte Übereinstimmung der elektrischen Kontakte im Steckverbinder mit den auf der Leiterplatte angeordneten Leiterbahnen sichergestellt ist.
Eine weitere Verbesserung der Führung der Leiterplatte zum Kartenrandsteckverbinder wird dadurch erzielt, indem die Leiterplatte gegen die untere Kante 8' des Steckschlitzes des Kartenrandsteckverbinders 6 gedrückt wird, wobei (unter Einbeziehung der Leiterplattenabmaße) eine leicht erhöhte Positionierung des unteren Steckschlitzrandes 8' des Kartenrandsteckverbinders 6 gegenüber der unteren Führungsschiene 14 vorgesehen ist.

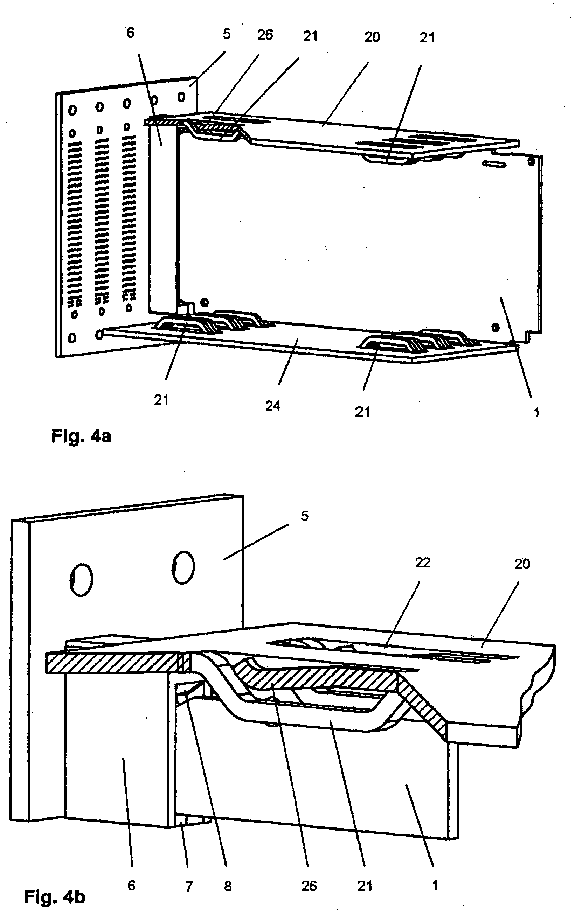

Die Fig. 4a zeigt einen Ausschnitt aus einem Leiterplatteneinschubgehäuse, bei dem die Leiterplatte zwischen einer Deckplatte 20 und einer Bodenplatte 24 in Führungsschienen gehalten ist, die aus henkelartig aus dem Plattenmaterial herausgeformten, in den Innenraum weisenden Führungsstreben 21 gebildet sind.
Jeweils zwei, beabstandet nebeneinander und im vorderen und hinteren Bereich angeordnete Führungsstreben, bilden eine Führungsschiene für eine darin einzuschiebende Leiterplatte 1.

In der vergrößerten Darstellung der Fig. 4b ist in einem Teilschnitt ein auf die Leiterplatte 1 wirkendes Federelement 26 ersichtlich, das aus dem Material der Deckplatte 20 herausgeformt ist und für einen Andruck der Leiterplatte 1 auf die Bodenplatte 24 sorgt.

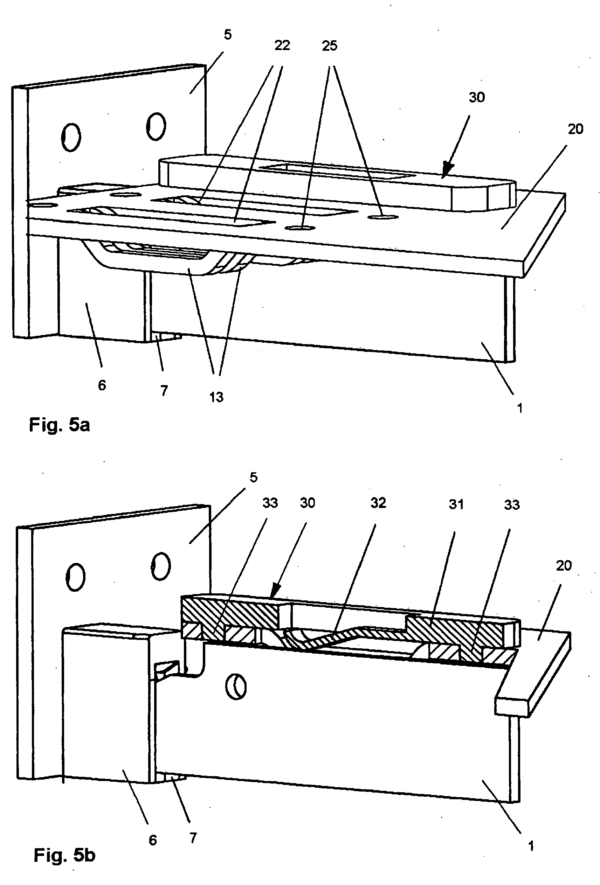

Für einen nachrüstbaren Einsatz bei einer Deckplatte, die kein angeformtes Federelement enthält, ist in der Fig. 5a ein separat anzuordnendes Federelement 30 gezeigt, das nachträglich montierbar ist.
Dazu ist das Federelement 30 in einem Kunststoffkörper 31 integriert, der in zwei standardmäßig bereits vorhandene oder auch nachträglich vorzusehende Öffnungen 25 in der Deckplatte 20 montiert wird.
Wobei ein aus dem Kunststoffkörper 31 herausgeformter Federarm 32 in einen Ausschnitt 22 eintaucht, der durch die nach innen gebogenen Führungstreben 21 gebildet ist. Somit wirkt der Federarm auf die hier obere Schmalseite 2 der Leiterplatte 1, wie in der Fig. 5b gezeigt.

Der Kunststoffkörper 31 des separaten Federelementes wird mittels zweier angeformter Raststifte 33, die in bereits in der Deckplatte 20 vorgesehenen oder einzubringende Öffnungen 25 verrastet.

## Patentansprüche

1. Vorrichtung, aufweisend eine Andruckvorrichtung mit einer oberen (10) und einer unteren (14) Führungsschiene, sowie eine zwischen den beiden Führungsschienen (10, 14) einschiebbare Leiterplatte (1), wobei innerhalb der oberen Führungsschiene (10) ein auf eine Schmalseite (2) der Leiterplatte (1) wirkendes Federelement (16, 26, 30) vorgesehen ist, **dadurch gekennzeichnet, dass** die Leiterplatte (1) an ihrer Steckseite eine Abstufung (3) und eine daran anschließende Kante (4) aufweist, auf welche das Federelement (16, 26, 30) beim endgültigen Einschieben der Leiterplatte (1) in einen Kartenrandsteckverbinder (6) wirkt und die Leiterplatte (1) dadurch gegen die untere Führungsschiene (14) drückt, um eine präzise Kontaktierung von auf der Leiterplatte (1) aufgebrachten Leiterbahnen zu entsprechenden, in dem Kartenrandsteckverbinder (6) angeordneten elektrischen Kontakten zu erzielen.

2. Vorrichtung nach Anspruch 1, **dadurch gekennzeichnet,**
**dass** die Führungsschienen als separat montierbare Führungsschienen (10, 14) ausgebildet sind, wobei das Federelement (16) in einer der Führungsschienen (10) in Schieberichtung ausgerichtet angeordnet ist.

3. Vorrichtung nach Anspruch 1, **dadurch gekennzeichnet,**
**dass** die Vorrichtung ein die Leiterplatte (1) umgebendes Leiterplattengehäuse mit einer Deckplatte (20) und einer Bodenplatte (24), aufweist, wobei die Führungsschienen (10, 14) als Führungsstreben (21) ausgebildet, beidseitig der Leiterplatte (1) in der Deckplatte (20) und der Bodenplatte (24) ausgebildet sind, wobei das Federelement (26) innerhalb der oberen Führungsstreben (21) als angeformtes Element in Schieberichtung der Leiterplatte (1) angeordnet ist.

4. Vorrichtung nach einem der vorstehenden Ansprüche, **dadurch gekennzeichnet,**
**dass** das Federelement (16) einseitig auf eine Schmalseite (2) der Leiterplatte (1) wirkend, nahe einer Abstufung (3) der gesteckten Leiterplatte (1) angeordnet ist.

## Claims

1. Apparatus having a contact-pressure apparatus with an upper guide rail (10) and a lower guide rail (14), and also having a printed circuit board (1) which can be inserted between the two guide rails (10, 14), wherein a spring element (16, 26, 30) which acts on a narrow side (2) of the printed circuit board (1) is provided within the upper guide rail (10), **characterized in that** the printed circuit board (1) has, on its plug-in side, a stepped portion (3) and an edge (4) which adjoins the said stepped portion and on which the spring element (16, 26, 30) acts when the printed circuit board (1) is finally inserted into a card-edge plug connector (6), and pushes the printed circuit board (1) against the lower guide rail (14) in this way in order to achieve a precise contact-connection between conductor tracks which are fitted to the printed circuit board (1) and corresponding electrical contacts which are arranged in the card-edge plug connector (6).

2. Apparatus according to Claim 1, **characterized in that** the guide rails are in the form of guide rails (10, 14) which can be mounted separately, wherein the spring element (16) is arranged in one of the guide rails (10) in a manner oriented in the sliding direction.

3. Apparatus according to Claim 1, **characterized in that** the apparatus has a printed circuit board housing which surrounds the printed circuit board (1) and has a covering plate (20) and a base plate (24), wherein the guide rails (10, 14), in the form of guide struts (21), are formed on both sides of the printed circuit board (1) in the covering plate (20) and the base plate (24), wherein the spring element (26) is arranged within the upper guide struts (21) in the form of an integrally formed element in the sliding direction of the printed circuit board (1).

4. Apparatus according to one of the preceding claims, **characterized in that** one side of the spring element (16) is arranged close to a stepped portion (3) of the plugged-in printed circuit board (1) such that it acts on a narrow side (2) of the printed circuit board (1).

## Revendications

1. Dispositif, comportant un dispositif de compression comprenant des rails de guidage supérieur (10) et inférieur (14) et une carte de circuit imprimé (1) pouvant être insérée entre les deux rails de guidage (10, 14), dans lequel il est prévu un élément à ressort (16, 26, 30) agissant sur un petit côté (2) de la carte de circuit imprimé (1) à l'intérieur du rail de guidage supérieur (10), **caractérisé en ce que** la carte de circuit imprimé (1) comporte sur son côté d'enfichage un gradin (3) et un bord (4) se raccordant à celui-ci, sur lequel l'élément à ressort (16, 26, 30) agit lors de l'insertion définitive de la carte de circuit imprimé (1) dans un connecteur de bord de carte (6) et la carte de circuit imprimé (1) appuie ainsi contre le rail de guidage inférieur (14) afin de d'obtenir une mise en contact précise de pistes conductrices déposées sur la carte de circuit imprimé (1) avec des contacts électriques correspondants disposés dans le connecteur de bord de carte (6).

2. Dispositif selon la revendication 1, **caractérisé en ce que** les rails de guidage sont réalisés sous la forme de rails de guidage (10, 14) pouvant être montés séparément, dans lequel l'élément à ressort (16) est disposé dans l'un des rails de guidage (10) en étant orienté dans la direction de coulissement.

3. Dispositif selon la revendication 1, **caractérisé en ce que** le dispositif comporte un boîtier de carte de circuit imprimé entourant la carte de circuit imprimé (1), ayant une plaque formant capot (20) et une plaque de fond (24), dans lequel les rails de guidage (10, 14) sont réalisés sous la forme d'arcs-boutants de guidage (21), et sont réalisés des deux côtés de la carte de circuit imprimé (1) dans la plaque formant capot (20) et la plaque de fond (24), dans lequel l'élément à ressort (26) est disposé à l'intérieur de l'arc-boutant supérieur (21) sous la forme d'un élément façonné dans la direction de coulissement de la carte de circuit imprimé (1).

4. Dispositif selon l'une quelconque des revendications précédentes, **caractérisé en ce que** l'élément à ressort (16) est disposé d'un seul côté, en agissant sur un petit côté (2) de la carte de circuit imprimé (1), à proximité d'un gradin (3) de la carte de circuit imprimé (1) enfichée.
